# DEMANDE DE BREVET EUROPEEN

(11) **EP 2 309 536 A1**
(43) Date de publication de la demande: **13.04.2011**
(21) Numéro de dépôt: 10185173.1
(22) Date de dépôt: 01.10.2010
(51) Int. Cl.: H01L 21/60

(54) **Assemblage de puces ou tranches semiconductrices par diffusion du matériau des plots de connexion dans un diélectrique claqué**

(30) Priorité: 08.10.2009 FR 0957044
(71) Demandeur: STmicroelectronics SA, 92120 Montrouge (FR); STMicroelectronics (Crolles 2) SAS, 38920 Crolles (FR)
(72) Inventeur: Felk, Yacine, 38000 Grenoble (FR); Chaabouni, Hamed, 38000 Grenoble (FR); Farcy, Alexis, 73490 La Ravoire (FR)
(74) Mandataire: de Beaumont, Michel

(57) **Abrégé**

L'invention concerne un procédé d'assemblage d'une première puce semiconductrice (P2) munie de plots (5B) sur une deuxième puce ou tranche semiconductrice (P1) munie de plots (5A), consistant à recouvrir la ou les puces d'un diélectrique (20), à superposer les deux puces (P1,P2), les plots (5A,5B) étant disposés sensiblement en regard, et à appliquer une différence de potentiel entre les plots (5A,5B) des première (P2) et deuxième (P1) puces de façon à provoquer un claquage du diélectrique (20) et une diffusion du conducteur constituant les plots (5A,5B) dans les zones claquées, d'où il résulte qu'il se forme un trajet conducteur (21) entre les plots en regard (5A,5B).

## Description

### Domaine de l'invention

La présente invention concerne un mode d'assemblage de puces/tranches semiconductrices.

### Exposé de l'art antérieur

Pour augmenter la compacité des circuits électroniques, on tend à superposer des puces semiconductrices directement reliées les unes aux autres pour réaliser ce qu'il est courant d'appeler une intégration tridimensionnelle (ou intégration 3D). Lors de cette assemblage, les puces de l'un et/ou l'autre des niveaux assemblés sont éventuellement encore regroupées sur une même tranche.

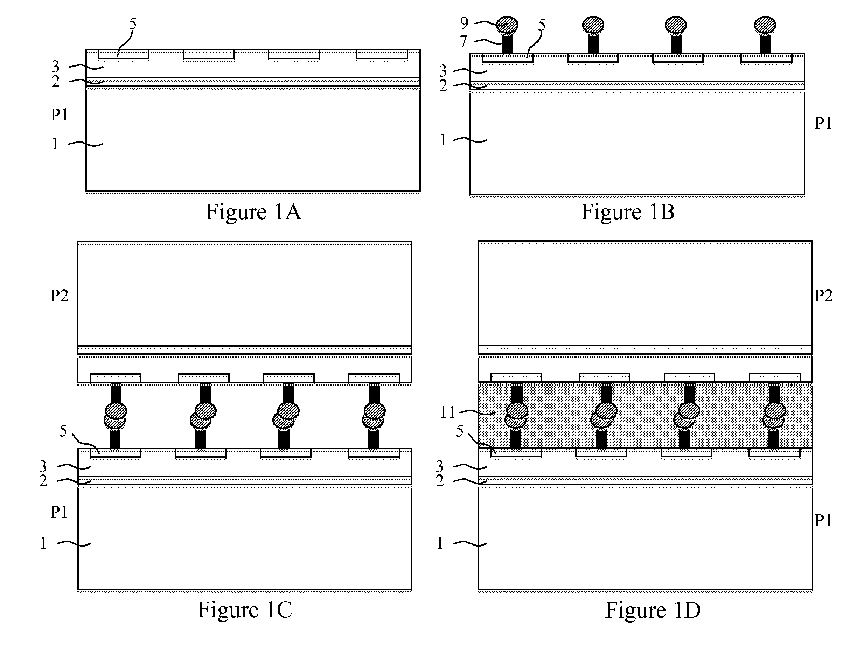

La figure 1A représente schématiquement une puce de circuit intégré formée à partir d'un substrat semiconducteur 1, couramment du silicium, dont une couche supérieure 2 contient des composants actifs, par exemple des circuits CMOS. Les composants actifs sont revêtus d'une partie supérieure 3 comprenant un grand nombre de niveaux d'interconnexion séparés par des couches isolantes et destinés notamment à assurer des connexions entre des régions des composants formés dans la couche 2 et des plots de contact 5.

Comme cela est illustré en figure 1B, pour permettre un assemblage face à face de puces de circuit intégré ou de puces de circuit intégré sur une tranche de circuit intégré, un procédé connu consiste à former par voie électrolytique sur chacun des plots un pilier 7, couramment en cuivre, sur lequel est disposé un chapeau en matériau de brasure 9, par exemple du SnAg.

Comme l'illustre la figure 1C, sur une première tranche ou puce P1équipée de piliers tels que ceux de la figure 1B, est placée une puce P2 équipée de piliers similaires de sorte que les chapeaux de brasure soit en regard les uns des autres. Ensuite, un chauffage est effectué pour que les chapeaux de brasure fondent et se resolidifient de façon à fixer la puce P2 à la puce ou tranche P1.

A une étape suivante, illustrée en figure 1D, l'intervalle entre les deux puces ou entre la puce et la tranche est rempli d'une résine 11.

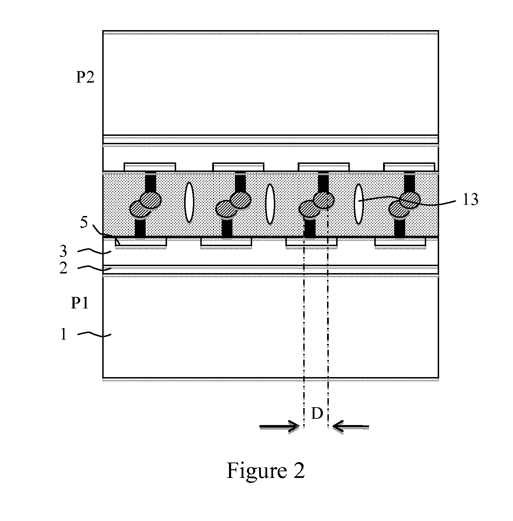

Le processus d'assemblage décrit ci-dessus est particulièrement délicat à mettre en oeuvre car, avec les appareils actuellement disponibles, il est difficile d'amener la puce P2 au dessus de la puce P1 avec une précision supérieure à ± 10 µm. Ce processus est donc sujet à des défauts d'alignement, désignés par la référence D en figure 2. En outre, il y a un risque que des bulles d'air 13 subsistent lors de l'injection de résine, notamment dans le cas où la densité de piliers est importante et/ou le diamètre des piliers est élevé en regard de leur densité. Ainsi, ce processus d'assemblage, même s'il a pu être mis en oeuvre de façon satisfaisante, entraîne de fortes limitations quant à la réduction maximum des dimensions que l'on peut obtenir, tant en ce qui concerne le diamètre des piliers que leur espacement.

### Résumé

Un objet de la présente invention est de prévoir un assemblage de puces et/ou de puces et de tranches de circuit intégré permettant d'obtenir une grande densité de connexions entre puces.

Un autre objet de la présente invention est de prévoir une telle structure évitant les défauts d'alignement.

Pour atteindre ces objets, un mode de réalisation de la présente invention prévoit un procédé d'assemblage d'une première puce semiconductrice munie de plots sur une deuxième puce ou tranche semiconductrice munie de plots, consistant à recouvrir la ou les puces d'un diélectrique, à superposer les deux puces, les plots étant disposés sensiblement en regard, et à appliquer une différence de potentiel entre les plots des première et deuxième puces de façon à provoquer un claquage du diélectrique et une diffusion du conducteur constituant les plots dans les zones claquées, d'où il résulte qu'il se forme un trajet conducteur entre les plots en regard.

Selon un mode de réalisation de la présente invention, les plots sont en cuivre.

Selon un mode de réalisation de la présente invention, le diélectrique est du SiO₂.

### Brève description des dessins

Ces objets, caractéristiques et avantages, ainsi que d'autres seront exposés en détail dans la description suivante de modes de réalisation particuliers faite à titre non-limitatif en relation avec les figures jointes parmi lesquelles :
les figures 1A à 1D sont des vues en coupe illustrant des étapes successives d'assemblage de puces ;
la figure 2 est une vue en coupe illustrant un assemblage de puces ;
les figures 3A à 3D sont des vues en coupe illustrant des étapes successives d'assemblage de puces selon un mode de réalisation de la présente invention ; et
les figures 4 et 5 sont des vues en coupe illustrant des variantes d'assemblage de puces selon un mode de réalisation de la présente invention.

Par souci de clarté, de mêmes éléments ont été désignés par de mêmes références aux différentes figures et, de plus, comme cela est habituel dans la représentation des circuits intégrés, les diverses figures ne sont pas tracées à l'échelle.

### Description détaillée

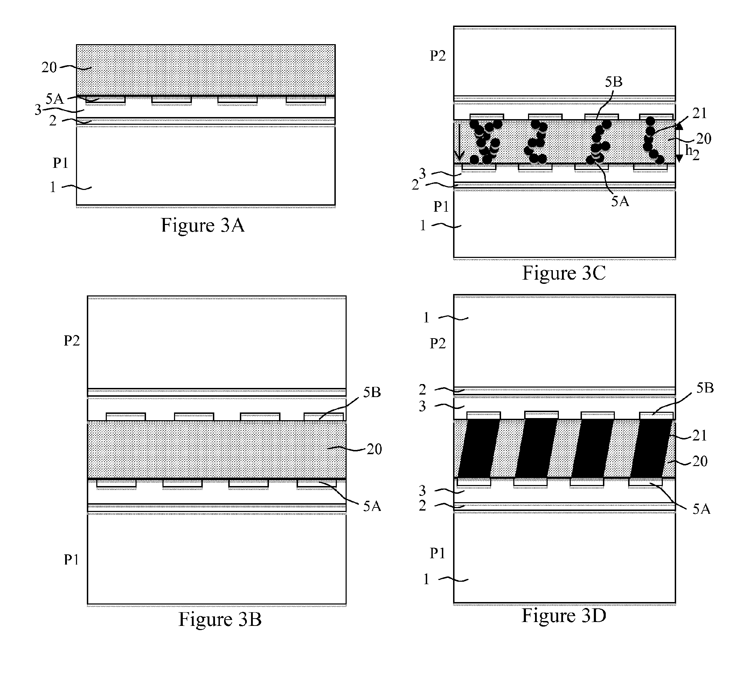

La figure 3A représente une puce ou tranche de circuit intégré P1 selon un mode de réalisation de la présente invention. Comme précédemment, cette puce comprend sur un substrat semiconducteur, couramment un substrat de silicium 1, une zone 2, couramment une couche épitaxiée, dans laquelle sont formés des composants, et un empilement d'interconnexion 3 en haut duquel sont formés des plots 5A. Sur cet assemblage, est formée une couche d'un diélectrique 20, par exemple du SiO₂ ou du SiOCH.

Ensuite, comme le représente la figure 3B, une puce P2, similaire à la puce ou tranche P1 est rapportée au dessus de la puce P1, de sorte que les plots 5B de la puce P2 soient en regard des plots 5A de la puce P1, avec un alignement aussi bon que possible.

Ensuite, une différence de potentiel est appliquée entre les plots des puces P1 et P2. Il en résulte que si la couche diélectrique est suffisamment mince pour la tension appliquée, il se produit un claquage du diélectrique dans lequel diffuse le métal des plots, par exemple du cuivre. Cette opération est de très courte durée, par exemple 1 à 10 ms.

On obtient, comme le représente les figures 3C et 3D, des zones conductrices 21 entre les plots supérieurs 5B et les plots inférieurs 5A.

On évite ainsi les inconvénients des dispositifs de l'art antérieur, à savoir qu'il ne peut y avoir de bulles d'air dans le diélectrique séparant la tranche ou puce inférieure de la puce supérieure, et que les défauts d'alignement éventuels des contacts sont compensés.

A titre de variante, après l'étape illustrée en figure 3A, on peut procéder, par exemple par immersion de la partie supérieure du diélectrique dans un liquide conducteur et application d'une tension entre les plots de la puce et le liquide conducteur, à la formation de zones de claquage dans lesquelles le conducteur des plots, et/ou des atomes conducteurs contenus dans la solution conductrice, diffusent pour fournir un résultat similaire à celui représenté en figure 3D, dans lequel la couche diélectrique comprend des zones conductrices. On reporte ensuite la puce supérieure. Cette variante de l'invention, si elle ne compense pas d'éventuels défauts d'alignement du positionnement de la puce supérieure sur la puce inférieure, permet au moins d'éviter l'apparition de bulles d'air dans le diélectrique intermédiaire entre les deux puces.

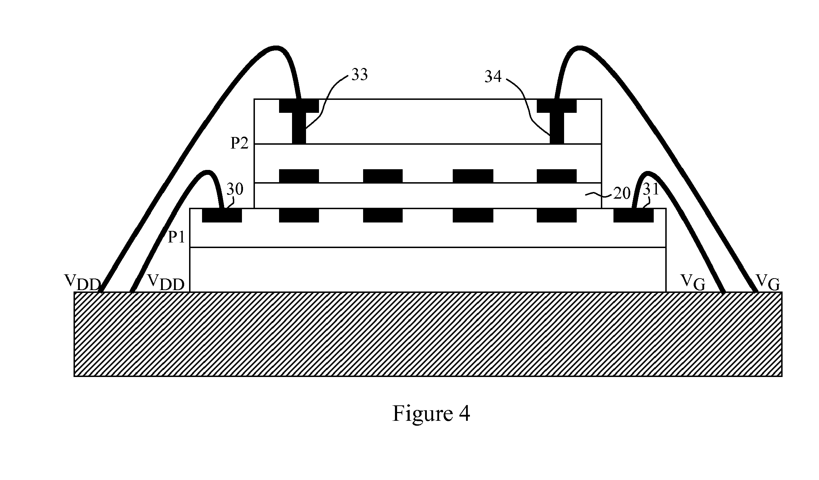

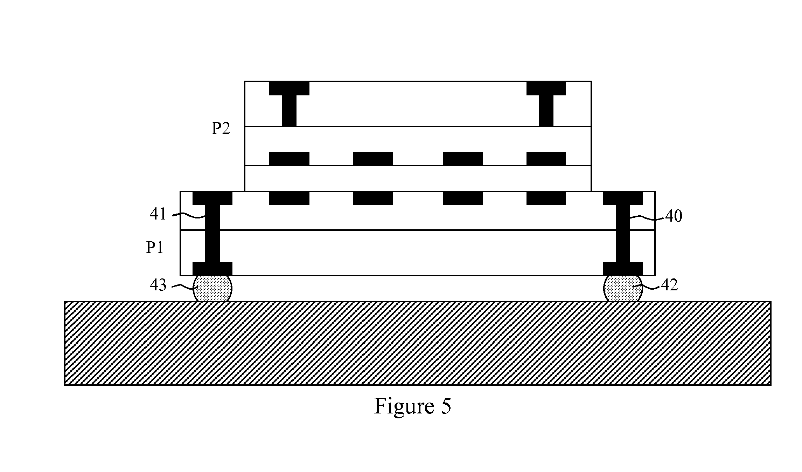

Pour établir les tensions électriques entre les plots des puces pendant la période de claquage, on pourra par exemple adopter une disposition telle que celle de la figure 4 ou de la figure 5.

Dans le cas de la structure de la figure 4, la puce ou tranche inférieure déborde par rapport à la puce ou tranche supérieure. Les plots extrêmes 30 et 31 de la puce inférieure sont connectés à des bornes d'alimentation haute et basse VDD et VG, respectivement. Du côté de la puce supérieure, des vias traversants (ou TSV) 33, 34 permettent d'établir des contacts avec les bornes d'alimentation de la puce supérieure et ces plots 33 et 34 sont respectivement connectés à des alimentations VDD et VG. Les deux puces étant alimentées, il est possible par conception de prévoir que, automatiquement, tous les amplificateurs (buffers) associés aux plots de la puce inférieure mettront ces plots à une première tension, par exemple VDD et tous les buffers associés aux plots de la puce supérieure mettront tous ces plots à une tension basse, par exemple VG. Alors, la différence VDD-VG entre les plots permettra de réaliser le claquage du diélectrique et la diffusion de métal conducteur pour assurer les connexions entre les plots des puces supérieure et inférieure.

Selon une variante illustrée en figure 5, on accède également aux plots de la puce inférieure par des vias traversants 40 et 41, reliés par des billes respectives 42 et 43 à des bornes d'alimentation. On alimente alors les puces inférieure et supérieure de la même façon que cela a été décrit précédemment pour obtenir entre des plots de ces puces des tensions suffisantes pour assurer la création de zones conductrices entre ces plots de la façon décrite précédemment.

Divers modes de réalisation avec diverses variantes ont été décrits ci-dessus. On notera que l'homme de l'art pourra combiner divers éléments de ces divers modes de réalisation et variantes sans faire preuve d'activité inventive.

A titre d'exemple numérique, chacune des puces peut comprendre jusqu'à 1000 plots en regard. Le champ à appliquer pour obtenir le claquage sera de l'ordre de 1 MV/cm, soit une tension de l'ordre de 1 V pour un diélectrique d'une épaisseur de 100 nm.

## Revendications

1. Procédé d'assemblage d'une première puce semiconductrice (P2) munie de plots (5B) sur une deuxième puce ou tranche semiconductrice (P1) munie de plots (5A), consistant à recouvrir la ou les puces d'oxyde de silicium (20), à superposer les deux puces, les plots étant disposés sensiblement en regard, et à appliquer une différence de potentiel entre les plots des première et deuxième puces de façon à provoquer un claquage du diélectrique et une diffusion du conducteur constituant les plots dans les zones claquées, d'où il résulte qu'il se forme un trajet conducteur entre les plots en regard.

2. Procédé selon la revendication 1, dans lequel les plots sont en cuivre.

## Revendications modifiées

### Revendications modifiées conformément à la règle 137(2) CBE.

**1.** Procédé d'assemblage d'une première puce semiconductrice (P2) munie de plots (5B) sur une deuxième puce ou tranche semiconductrice (P1) munie de plots (5A), consistant à recouvrir la ou les puces de SiO₂ ou de SiOCH (20), à superposer les deux puces, les plots étant disposés sensiblement en regard, et à appliquer une différence de potentiel entre les plots des première et deuxième puces de façon à provoquer un claquage du diélectrique et une diffusion du conducteur constituant les plots dans les zones claquées, d'où il résulte qu'il se forme un trajet conducteur (21) entre les plots en regard.

**2.** Procédé selon la revendication 1, dans lequel les plots sont en cuivre.
